# EUROPEAN PATENT APPLICATION

(11) **EP 2 214 215 A1**
(43) Date of publication of application: **04.08.2010**
(21) Application number: 09151595.7
(22) Date of filing: 29.01.2009
(51) Int. Cl.: H01L 31/18, B23K 26/42

(54) **Scribing Device and Method of Producing a Thin-Film Solar Cell Module**

(71) Applicant: Applied Materials Inc., A Corporation Of The State Of Delaware, Santa Clara, California 95054 (US)
(72) Inventor: Repmann, Tobias, 63755, Alzenau (DE); Straub, Axel, 55218, Ingelheim (DE)
(74) Representative: Lermer, Christoph

(57) **Abstract**

A laser scribing device 20 is provided which comprises at least a laser light source 21. The laser light source 21 may generate a laser beam 22 for scribing cell lines 12a, 12b,...;13a, 13b,...; 14a, 14b,... to form a patterned solar cell module 10. Furthermore, the laser 21 may emit a light beam 23 for generating a light spot 24 on the surface of the solar cell module. The light beam 23 may be modulated compared with the light beam 22 used for the scribing process. By means of the light spot 24 a particular region of the active area 18 of the solar cell module may be illuminated, and the voltage V_{OC} (L) may be measured at a voltage measurement device 25. The voltage measurement device 25 is connected between the negative contact area 15 and the positive contact area 16 of the solar cell module 10. The measured voltage V_{OC} (L) depends on the location of the laser spot 24 on the solar cell module 10 and the intensity of the laser spot 24.

## Description

### TECHNICAL FIELD

The present invention relates to a scribing device for sectioning at least a layer of a solar cell module having a first contact electrode and a second contact electrode, wherein said scribing device comprises at least a light source adapted for locally illuminating different areas of said solar cell module. Furthermore the present invention relates to a method of producing a solar cell module having a first contact electrode and a second contact electrode, comprising the steps of: a) depositing a layer on a substrate; and b) sectioning said layer deposited on said substrate by means of a scribing tool for forming electrically insulated sections of said layer.

### PRIOR ART

The development of thin-film solar cell modules enables high-volume manufacturing of solar cells at greatly reduced silicon consumption. Therefore, fabrication costs per unit of power output could be considerably decreased compared to conventional silicon-waver based solar cells.

Thin-film solar cells consist of a stack of thin layers of material deposited on a sheet glass substrate. Usually, thin-film solar cells comprise at least a first transparent contact layer (e.g. a transparent conductive oxide TCO layer), a semiconductor layer having a junction configuration (e.g. based on amorphous silicon), and a second electrode layer. However, there are also multi-junction configurations such as tandem structures.

Due to the fact that the output voltage of a solar cell module depends on the band gap, whereas the output current increases with the surface of a solar cell module, large-area solar cell modules output quite high current compared with low voltages.

In order to decrease the current while increasing the voltage the solar cell module is cut into smaller cell sections connected in series. The interconnections between the smaller solar cell sections are produced during the fabrication of the panel. For example, at the beginning of the production process a first conductive layer (e.g. TCO) is deposited on a substrate. The first conductive layer is divided into strip-shaped portions by a first scribing process (P1). Afterwards a semiconductor layer is deposited on top of the first electrode layer. The semiconductor layer is also divided into a plurality of strip-shaped portions by a second scribing process (P2). Afterwards, a second contact is deposited on top of the semiconductor layer and also divided into strip-shaped portions by a third scribing process (P3). After each scribing process the respective strips are electrically insulated relative to each other by recesses/gaps manufactured in the scribing process.

Conventional scribing processes include etching, chemical scribing or laser scribing. However, laser scribing is getting a very significant technology as it enables high-volume production at high quality and speed. However, the reliability of these scribing processes is limited. Residual material or bad quality of the scribing process may cause unacceptable malfunctioning of the solar cell module.

### OBJECT OF THE INVENTION

It is an object of the present invention to provide a scribing device and a method of producing a thin-film solar cell module allowing high-volume production and providing an increased quality of thin-film layer solar cell modules.

### TECHNICAL SOLUTION

This problem is solved by providing a scribing device according to claim 1 and a method of producing a thin-film solar cell module according to claim 9. The features of the dependent claims refer to preferred embodiments of the invention.

An inventive scribing device for sectioning at least a layer of a solar cell module having a first contact electrode and a second contact electrode, wherein the scribing device comprises at least a light source adapted for locally illuminating different areas of the solar cell module, is **characterized in that** the scribing device comprises at least a measuring device for measuring a signal between the first contact electrode and the second contact electrode of the solar cell module responsive to the location of the area of the solar cell module illuminated by the light source.

Usually the solar cell module is a thin-film solar cell module having at least a first electrode layer, e.g. a transparent conductive oxide layer, a semiconductor layer, e.g. an amorphous silicone layer, and a second electrode layer, e.g. a Mo or Al layer. The thin-film solar cell module comprises a plurality of strip-shaped solar cell sections, each of them having at least a first electrode layer, a semiconductor layer, and a second electrode layer. A section of the first electrode layer of a strip-shaped section of the solar cell module is separated and electrically insulated from adjacent sections of the first electrode layer. A section of the semiconductor layer of a strip-shaped section of the solar cell module is separated and electrically insulated from each adjacent section of the semiconductor layer. A section of the second electrode layer of a strip-shaped section of the solar cell module is separated and electrically insulated from each adjacent section of the second electrode layer. Furthermore, the thin-film solar cell module comprises a first (negative) contact electrode connected at least with a section of the first electrode layer and a second (positive) contact electrode connected at least with a section of the second electrode layer.

The scribing device may be used for qualifying, measuring, monitoring and/or controlling the functional capability of the solar cell module or a particular solar cell section. Particularly the efficiency of each of the strip-shaped solar cell sections, the electric insulation between two adjacent strip-shaped solar cell sections, the shunt resistance, etc., may be determined. The device used for qualifying/measuring the functional capability of the solar cell sections of a solar cell module and/or of the solar cell module may be a shunt scanning unit.

The measuring method comprises the steps: a) providing a solar cell module as mentioned above; b) locally and selectively illuminating a particular area of the surface of the solar cell module by means of light emitted from a light source; and c) measuring a signal by means of a measuring device connected with the first contact electrode and/or the second contact electrode responsive to the location of the illuminated area of the solar cell module. For the measurement of different solar cell sections of a solar cell module there are only two contacts required, namely a positive contact and a negative contact of the solar cell module.

Besides, the device may especially be used for monitoring or controlling the scribing process. The standard manufacturing process includes some sectioning/ scribing/ patterning steps e.g. three laser scribing steps P1, P2 and P3 as mentioned above. Furthermore, an isolation line is formed which at least partly surrounds the active area of the module to electrically insulate the active area of the solar cell module at the edges thereof. The measurement is carried out as mentioned above. The results of the measurement may be used to qualify the laser scribe process and to control the laser scribe process by changing the laser power for the next cell scribe or for initiating a re-scribe of the scribe line in order to get a better cell-to-cell insulation. The monitoring and/or control of the scribing process is particularly important for the P3 scribing process, i.e. when scribing the second electrode layer. The measuring method may be repeated after each (P3) cell sectioning scribe and/or after finishing the (P3) scribing process and/or during the (P3) scribing process.

The light source may be a single wavelength light source (e.g. a laser diode) or a small wavelength band light source (e.g. an LED). In the measurement the response signal at a particular illumination wavelength may be measured. When using different wavelengths spectral information about the performance of a solar cell section and the solar cell module may be obtained.

It is preferred that the scribing device may comprise at least a scribing tool for forming electrically insulated areas of said layer. The scribing tool may be particularly used for scribing the (P3) insulation line around the active area of the solar cell module and/or for scribing the cell lines between the solar cell sections of the solar cell module. The tool is usually configured for sectioning the active area by generating strip-shaped cell sections.

In a preferred embodiment of the invention the light source is configured for providing light for illuminating different areas of the solar cell module and for sectioning the layer of the solar cell module by means of a light scribing process. The light source may be integrated in the scribing tool.

In a preferred embodiment of the invention the light source may comprise at least a laser light source. The light source may be a laser, particularly the same laser used for laser scribing. The light intensity and/or the cross-section dimension of the laser beam may be adapted before beginning with the measurement of the solar cell module after a scribing process.

The scribing tool may be configured as a laser scribing tool. Laser scribing enables high-volume production of solar cell modules at high quality and speed.

It is preferred that the scribing device is configured for illuminating different areas of the solar cell module by means of relative movement of the light beam emitted from the light source relative to the surface of the solar cell module. The scribing device may e.g. comprise a (laser) scanner for scanning the surface of the solar cell module. In another embodiment there may be a fixed light beam and a device for moving the solar cell module instead.

In another preferred embodiment of the invention the scribing device comprises a plurality of light sources arranged to illuminate different areas of the solar cell module by selectively switching the light sources. The light sources may be arranged adjacent to each other above the surface of the solar cell module, each of the light sources arranged for illuminating a particular area of the solar cell module. When switching the light sources one after the other, a "moving" light source may be simulated. The measurement includes measuring signals at or between the contact electrodes of the solar cell module responsive to the location of the illuminated area.

Particularly, the measuring device comprises a voltage measuring device for measuring a voltage between the first contact electrode and the second contact electrode of the solar cell module. The measured signal may be an open circuit voltage, an electric current, an electric resistance or any other electric signal generated by the illuminated solar cell sections. The solar cell sections may be illuminated successively by means of the light source(s). Each cell section may be qualified, while only the two contacts of the solar cell module have to be contacted.

According to the invention a method of producing a thin-film solar module having a first contact electrode and a second contact electrode comprises the steps of: a) Depositing at least one layer on a substrate; and b) Sectioning the layer deposited on the substrate by means of a scribing tool for forming electrically insulated sections of the layer; and c) monitoring and/or controlling the process step b) by locally and/or selectively illuminating at least one particular area of a surface of the solar cell module with light emitted from a light source, and measuring a signal by means of a measuring device connected with the first contact electrode and/or the second contact electrode responsive to the location of the illuminated area of the solar cell module.

Particularly, the process is carried out in a P3 scribing process for forming a second electrode layer deposited on a layer stack. Usually in the P3 scribing process electrically insulated stripe-shaped areas of a second electrode layer are formed by means of the scribing tool.

The process step c) may be carried out during the sectioning step b) or after termination of the sectioning process step b). The monitoring and/or controlling step c) includes a step of qualifying and/or measuring the functional capability of a thin-film solar cell as described above.

It is preferred that the light source is used for removing material in said sectioning step b) by means of a light beam emitted from said light source, and the light source is used in the process step c) for illuminating at least on particular area of said solar cell module. For example, the scribing tool comprises a laser light source which is used for illuminating one particular area of the surface of the solar cell module in process step c), and for sectioning the second electrode layer in process step b) in a laser scribing process.

Particularly, the beam emitted from the light source is modified when using the light source for a sectioning step b) and for a monitoring and/or controlling step, respectively. For example, the diameter of a light beam or light spot may be adapted as well as the intensity of the light source.

Furthermore, different wavelengths may be used during the process steps b) and/or c) in order to get a suitable wavelength for each of the process steps. Furthermore, while varying the wavelength of light used in process step c), spectral information about the characteristics of the solar cell sections may be obtained.

The process step b) may include scribing an insulation line which electrically insulates at least a part of an active area of the solar cell module from an edge portion of the solar cell module. The insulation line at least partly surrounds the active area of the solar cell module. The insulation line electrically insulates the active area of the solar cell module from the proximity.

Furthermore, the process step b) may include scribing cell (sectioning) lines for electrically insulating a first area of the layer from adjacent areas of the layer. A cell line electrically insulates a first strip-shaped area/cell section of e.g. the second electrode layer from an adjacent cell section of the second electrode layer. It is advantageous forming the P3 insulation line before forming the cell sectioning lines. In this way, the performance of each of the sections and of the cell sectioning line may be measured after a process step b).

It is usually advantageous to scribe the insulation line (e.g. P3 insulation line) before scribing the P3 cell lines. Thus, each P3 scribe or sectioning line insulates a recently formed cell section against the minus contact electrode of the solar cell module. By illuminating a portion of a recently formed cell section and measuring a signal the insulation and performance of this cell section may be measured by means of a measuring device which is only connected with the first contact electrode and/or the second contact electrode of the solar cell module. E.g. the performance of each cell sectioning scribe may be measured and determined immediately after each additional scribe. It is not necessary to contact the cell section to be characterized directly before the measurement.

It is preferred that he process step c) includes scanning the surface of the solar cell module with light emitted from the light source. The system is provided for scanning in a lateral/transverse direction relative to the longitudinal axis of the strip-shaped cell sections, particularly in a perpendicular direction. The longitudinal axis is substantially an axis parallel to the cell sectioning lines. Scanning means moving the light spot or light beam relative to the surface of the solar cell module. Different areas of a solar cell module are illuminated by means of relative movement of a light beam emitted from the light source and the surface of the solar cell module. The light beam emitted from the light source may be movable over the surface, and/or the surface of the solar cell module may be arranged movable relative to light beam emitted from the light source. The scribing device may include a scanner for scanning at least along a line transverse to the longitudinal axis of the surface of the solar cell module.

The relative movement may be simulated by providing a plurality of light sources arranged in-line or in a raster pattern above the solar cell section. By switching the light sources a virtually moving light source may be generated by switching from one light source to the next.

During scanning the measurement device measures signals which are responsive to cell-to-cell insulation properties and/or to the performance of a particular cell section. The measuring device measures a signal at the two contacts of the solar cell module.

It is preferred that the method includes further process steps d) evaluating the measured signal; and e) changing an input parameter of the scribing tool when repeating the process step b) to generate another scribe line and/or repeating the process step b) to improve a generated scribe line. It is also possible to illuminate a cell section during a sectioning step b) for providing an on-line (real time) control of a sectioning step b).

It is preferred that the signal measured in process step c) is a voltage signal, an electric current signal and/or a resistance signal. For example, the signal may be an open circuit voltage. The signal may depend on the light intensity and/or the shunt resistance of an illuminated cell section. The spot of the light is particularly so small that it may be adjusted to illuminate just one cell section or a part thereof.

### BRIEF DESCRIPTION OF THE DRAWINGS

Further features and advantages of the invention will be apparent from the following description of preferred embodiments and the appended drawings. The figures illustrate
- Figure 1: process steps for manufacturing a thin-film solar cell module using a scribing device according to the present invention;
- Figure 2: a top view of a schematic illustration of a thin-film solar cell module and a scribing device according to the present invention; and
- Figure 3: a side view of a schematic illustration of a thin-film solar cell module and a scribing device according to the present invention.

### DESCRIPTION OF PREFERRED EMBODIMENTS OF THE INVENTION

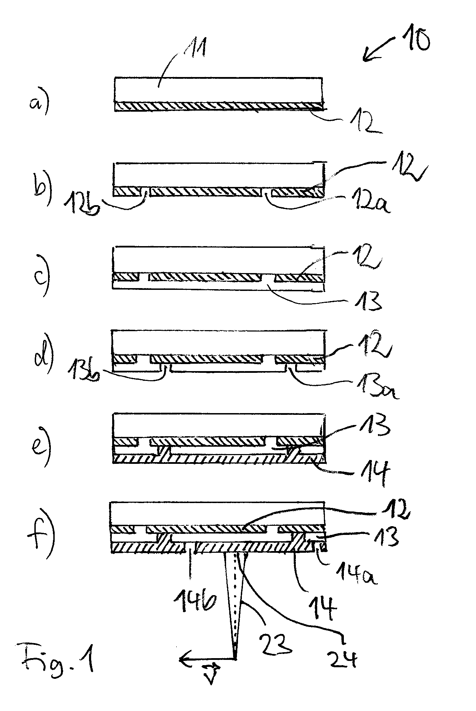

Figure 1 illustrates process steps a) to f) in the production process of a thin-film solar cell module 10 using a scribing device according to the present invention.

In a first process step a) a TCO (transparent conductive oxide) layer 12 is deposited on a glass substrate e.g. a sheet of glass 11. The TCO layer forms a front electrode of the solar cell module 10.

In a subsequent process step b) a first scribe process (P1) is carried out using a laser scribing device according to the present invention. The laser of the scribing device scribes through the entire TCO layer 12 to form gaps 12a and 12b between strip-shaped sections to electrically insulate adjacent sections of the layer 12.

In a process step c) a silicon layer 13 is formed on top of the electrode layer 12 filling the gaps 12a and 12b with silicon material.

Afterwards, in a process step d) a second scribe process (P2) is carried out using a laser scribing device according to the present invention. The laser of the scribing device scribes through the entire semiconductor layer 13 to form gaps 13a and 13b between strip-shaped sections to electrically insulate adjacent sections of the layer 13. The gaps 13a and 13b between adjacent sections of the semiconductor layer 13 are laterally offset relative to the gaps 12a and 12b between adjacent sections of the TCO layer 12.

In a process step e) a second electrode layer 14 e.g. an Al or Mo layer, is formed on top of the silicon layer 13 filling the gaps 13a and 13b to contact the first electrode layer 12.

In a process step f) a third scribe process step (P3) is carried out using a laser scribing device according to the present invention. The laser of the scribing device scribes through the entire electrode layer 14 to form gaps 14a and 14b between strip-shaped sections to electrically insulate adjacent sections of the layer 14. The third scribe process forms a pattern of electrodes sections in the second electrode layer 14 separated by gaps 14a and 14b. The gaps 14a and 14b are laterally offset relative to the gaps 13a and 13b of the semiconductor layer 13 and the gaps 12a and 12b of the TCO layer 12.

According to the invention, during or after process step f), i.e. after isolating a particular section in the electrode layer 14 or after terminating the scribe process P3, a laser beam 23 illuminates an area 24 (laser spot) of the solar cell module 10 to determine the quality of the scribe lines 14a, 14b and/or the quality of the corresponding illuminated section of the solar cell module 10. Furthermore, the laser beam 23 may scan the surface of the solar cell module 10 at a speed v to measure the quality of each of the sections and the scribe lines and control parameters of the scribe process, e.g. for scribing the next P3 lines or repeating a P3 scribe.

The laser generating the laser beam 23 may be the same laser which is used for at least one of the scribe processes P1, P2 and P3. The laser beam 23 may be modified (e.g. the intensity or diameter of the spot 24) when performing a scribe and a measurement scan, respectively.

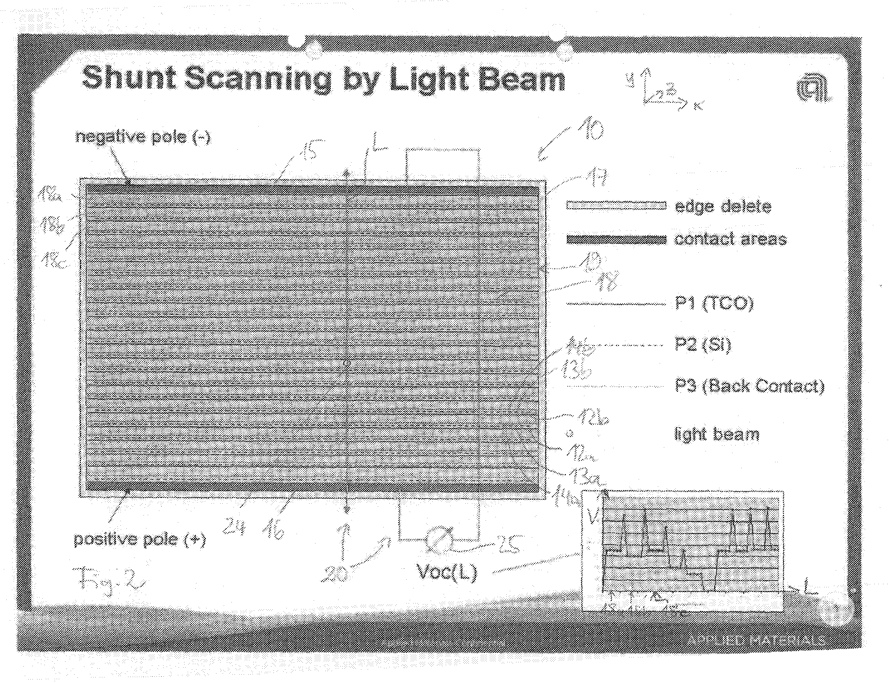

Figure 2 shows a top view of a complete solar cell module 10 and a scribing device 20 according to the invention.

The solar cell module 10 consists of a first electrode layer (TCO layer), a silicon layer and second electrode layer deposited on a substrate as a layer stack. Each of the layers is separated in strip-shaped sections extending along the longitudinal axis x of the sections. The first scribe lines 12a, 12b of the first electrode layer are indicated by continuous lines. The scribe lines 13a, 13b separating the strip-shaped sections of the silicon layer are indicated by dashed lines. The scribe lines 14a, 14b separating the strip-shaped sections of the second electrode layer are indicated by further continuous lines 14a, 14b. Figure 1 f) is a portion of a cross sectional view along a plane yz of figure 2.

Furthermore, the solar cell module 10 comprises two contact areas, namely a negative contact 15 and a positive contact 16. The cell sections of the solar cell module 10 are switched in line between the contacts 15 and 16. The active area 18 of the solar cell module 10 is surrounded by an edge delete 17 which is separated from the electrically active area 18 by an insulation line 19 which is formed in at least one of the scribing processes P1, P2 and P3. It is advantageous to scribe the insulation line 19 before scribing the P3 scribing lines 14a and 14b. After scribing the insulation line 19 each cell line 14a, 14b generates a new insulated solar cell section. Therefore, an open circuit voltage V_{OC} (L) may be measured after every P3 scribe. Generally, when scribing a new electrically insulated cell section the voltage V_{OC} (L) may change.

Between the contact areas 15 and 16 a voltage is generated when light impinges the active area 18 of the solar cell module 10. The signal generated by a light spot 24 may be measure by a voltage measurement device. The signal may be an open circuit voltage V_{OC} (L) which depends on the intensity of the laser spot 24 and the location laser spot 24. The voltage V_{OC} (L) is measured between the two contacts 15 and 16 of the solar cell module 10.

The result of a measurement when scanning a laser spot 24 along a line L (y-direction) is illustrated in the diagram in figure 2. The voltage V_{OC} (L) depends on the location L of the spot 24 along the scanning line L. The measured voltage value V_{OC} (L) in locations 18a, 18b, 18c,... indicates the quality of the solar cell sections 18a, 18b, 18c,.., particularly the quality of the scribing process P3. Furthermore, the open circuit voltage V_{OC} (L) depends on the shunt resistance and the location of the shunt on an individual cell section due to the resistivity of the front electrode and the back electrode of the cell section. The peaks in the illustration indicate transitions of the laser spot 24 from a particular cell section to the next adjacent cell section. Each time the light spot moves from a cell section to the next cell section, the voltage signal has a peak according to the sum of the open circuit voltages V_{OC} (L) from each of the illuminated cell sections. By means of this peak the V_{OC} (L) signal for each cell section may be separated from the signal of the adjacent cell section in the diagram. Due to the fast response time when measuring the V_{OC} (L) signal the scan speed v may be quite high and the shunt information of each individual cell may be collected in only one scan per module. When scanning the solar cell module 10 in different positions x along the longitudinal axis of a solar cell module 10 (scanning direction y) a three-dimensional pattern including information about the shunt location may be obtained.

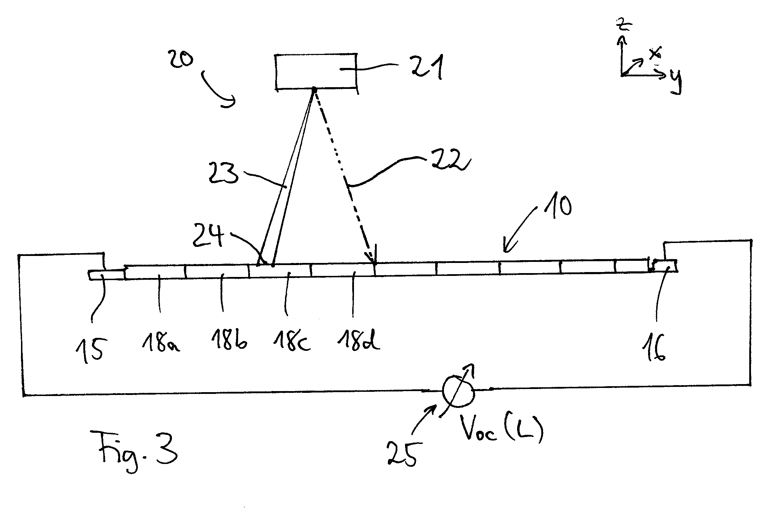

Figure 3 illustrates a cross-sectional view of a solar cell module 10 similar to the one shown in figure 2.

According to the invention a laser scribing device 20 is provided which comprises at least a laser light source 21. The laser light source 21 may generate a laser beam 22 for scribing the insulation line 19 (cf. figure 2) and/or the cell lines 12a, 12b,...;13a, 13b,...; 14a, 14b,... to form a patterned solar cell module 10. There may be more than one laser 21 for simultaneous laser scribing processes and/or for different scribing processes, e.g. P1, P2 and/or P3.

Furthermore, the laser 21 may emit a light beam 23 for generating a light spot 24 on the surface of the solar cell module. The light beam 23 may be modulated compared with the light beam 22 used for the scribing process. By means of the light spot 24 a particular region of the active area 18 of the solar cell module may be illuminated, and the voltage V_{OC} (L) may be measured at a voltage measurement device 25. The voltage measurement device 25 is connected between the negative contact area 15 and the positive contact area 16 of the solar cell module 10. The measured voltage V_{OC} (L) depends on the location of the laser spot 24 on the solar cell module 10 and the intensity of the laser spot 24.

Due to the fact that the strip-shaped cell sections 18a, 18b, 18c,... are switched in line between the contact areas 15 and 16 the voltage generated in the cell section 18a, 18b, 18c,... adds up to a cell module voltage. If only one or a few sections are illuminated according to the present invention conclusions about the illuminated cell section(s) may be drawn.

The inventive scribing device 20 may have one laser for generating a laser scribing beam 22 and a measurement laser beam 23, or the scribing device 20 may have two or more lasers 21 for generating a laser scribing beam 22 and/or a measurement laser beam 23.

The measurement device integrated in the scribing device 20 may be used for checking, monitoring and/or controlling a scribing process, particularly the P3 scribe process, and/or for qualifying a shunt resistance of the manufactured solar cell module 10.

Instead of a laser beam 23 generating a laser spot 24 any other suitable light source may be integrated in the scribing device 20 according to the present invention. For example, any single wavelength light source or small wavelength band light source (e.g. an LED) may be used instead of a laser light source. When using different wavelengths spectral information about the solar cell module and cell section performance may be the obtained.

## Claims

1. A scribing device (20) for sectioning at least a layer (14) of a solar cell module (10) having a first contact electrode (15) and a second contact electrode (16), wherein said scribing device comprises at least a light source (21) adapted for locally illuminating different areas (24) of said solar cell module (10),
**characterized in that**
said scribing device (20) comprises at least a measuring device (25) for measuring a signal between said first contact electrode (15) and said second contact electrode (16) of said solar cell module (10) responsive to the location (L) of said area (24) of said solar cell module (10) illuminated by said light source (21).

2. The scribing device according to claim 1, **characterized in that**
said scribing device (20) comprises at least a scribing tool for forming electrically insulated areas of said layer (14).

3. The scribing device (20) according to claim 2, **characterized in that**
said light source (21) is configured for providing light for illuminating different areas (24) of said solar cell module (10) and for sectioning said layer (14) of said solar cell module (10) by means of a light scribing process.

4. The scribing device (20) according to any of the previous claims, **characterized in that** said light source (21) comprises at least a laser light source.

5. The scribing device (20) according to any of the previous claims, **characterized in that** said scribing tool is configured as a laser scribing tool.

6. The scribing device (20) according to any of the previous claims,
**characterized in that**
said scribing device (20) is configured for illuminating different areas (24) of said solar cell module (10) by means of relative movement of the light beam (24) emitted from the light source (21) relative to the surface of the solar cell module (10).

7. The scribing device (20) according to any of the previous claims,
**characterized in that**
said scribing device comprises a plurality of light sources (21) arranged to illuminate different areas of said solar cell module (10) by selectively switching said light sources (21).

8. The scribing device (20) according to any of the previous claims,
**characterized in that**
said measuring device (25) comprises a voltage measuring device for measuring a voltage between said first contact electrode (15) and said second contact electrode (16) of said solar cell module (10).

9. A method of producing a solar cell module (10) having a first contact electrode (15) and a second contact electrode (16), comprising the steps of:
a) Depositing a layer (14) on a substrate; and
b) Sectioning said layer (14) deposited on said substrate by means of a scribing tool (20) for forming electrically insulated sections of said layer (14);
**characterized in that**,
said method further comprises a step
c) monitoring and/or controlling said process step b) by locally and selectively illuminating at least one particular area (24) of a surface of said solar cell module (10) with light emitted from a light source (21), and measuring a signal by means of a measuring device (25) connected with said first contact electrode (15) and said second contact electrode (16) responsive to the location (L) of said illuminated area (24) of said solar cell module (10).

10. The method according to claim 9, **characterized in that**
said light source (21) is used for removing material in said sectioning step b) by means of a light beam emitted from said light source (21), and
said light source (21) is used in said process step c) for illuminating at least on particular area of said solar cell module (10).

11. The method according to claim 9 or 10, **characterized in that**
said light emitted from said light source (21) is modified when using said light of said light source (21) for said process step b) and said process step c), respectively.

12. The method according to any of the previous claims 9 to 12, **characterized in that** said process step b) includes scribing an insulation line which electrically insulates at least a part of an active area (18) of said solar cell module (10) from an edge portion (17) of said solar cell module (10).

13. The method according to any of the previous claims 9 to 13, **characterized in that** said process step b) includes scribing cell lines (14a, 14b,...) for electrically insulating a first area of said layer (14) from adjacent areas of said layer (14).

14. The method according to any of the previous claims 9 to 14, **characterized in that** said process step c) includes scanning said surface of said solar cell module (10).

15. The method according to any of the previous claims 9 to 14, **characterized in that** said method includes further process steps
d) Evaluating the measured signal; and
e) Changing an input parameter of said scribing tool when repeating said process step b) to generate another scribe line and/or repeating said process step b) to improve a generated scribe line.

## Amended claims

### Amended claims in accordance with Rule 137(2) EPC.

**1.** A scribing device (20) for sectioning at least a layer (14) of a solar cell module (10) having a first contact electrode (15) and a second contact electrode (16), wherein said scribing device comprises at least a light source (21),
**characterized in that**
said light source (21) is adapted for locally illuminating different areas (24) of said solar cell module (10) in order to generate electric current or electric voltage between the contact electrodes (15, 16), wherein
said scribing device (20) comprises at least a measuring device (25) connected with said first contact electrode (15) and said second contact electrode (16) for measuring a signal between said first contact electrode (15) and said second contact electrode (16) of said solar cell module (10) responsive to the location (L) of said area (24) of said solar cell module (10) illuminated by said light source (21).

**2.** The scribing device according to claim 1, **characterized in that**
said scribing device (20) comprises at least a scribing tool for forming electrically insulated areas of said layer (14).

**3.** The scribing device (20) according to claim 2, **characterized in that**
said light source (21) is configured for providing light for illuminating different areas (24) of said solar cell module (10) and for sectioning said layer (14) of said solar cell module (10) by means of a light scribing process.

**4.** The scribing device (20) according to any of the previous claims, **characterized in that**
said light source (21) comprises at least a laser light source.

**5.** The scribing device (20) according to any of the previous claims, **characterized in that**
said scribing tool is configured as a laser scribing tool.

**6.** The scribing device (20) according to any of the previous claims,
**characterized in that**
said scribing device (20) is configured for illuminating different areas (24) of said solar cell module (10) by means of relative movement of the light beam (24) emitted from the light source (21) relative to the surface of the solar cell module (10).

**7.** The scribing device (20) according to any of the previous claims,
**characterized in that**
said scribing device comprises a plurality of light sources (21) arranged to illuminate different areas of said solar cell module (10) by selectively switching said light sources (21).

**8.** The scribing device (20) according to any of the previous claims,
**characterized in that**
said measuring device (25) comprises a voltage measuring device for measuring a voltage between said first contact electrode (15) and said second contact electrode (16) of said solar cell module (10).

**9.** A method of producing a solar cell module (10) having a first contact electrode (15) and a second contact electrode (16), comprising the steps of:
a) Depositing a layer (14) on a substrate; and
b) Sectioning said layer (14) deposited on said substrate by means of a scribing tool (20) for forming electrically insulated sections of said layer (14);
**characterized in that**,
said method further comprises a step
c) monitoring and/or controlling said process step b) by locally and selectively illuminating at least one particular area (24) of a surface of said solar cell module (10) with light emitted from a light source (21) in order to generate electric current or electric voltage between the contact electrodes (15, 16), and measuring a signal by means of a measuring device (25) connected with said first contact electrode (15) and said second contact electrode (16) responsive to the location (L) of said illuminated area (24) of said solar cell module (10).

**10.** The method according to claim 9, **characterized in that**
said light source (21) is used for removing material in said sectioning step b) by means of a light beam emitted from said light source (21), and
said light source (21) is used in said process step c) for illuminating at least on particular area of said solar cell module (10).

**11.** The method according to claim 9 or 10, **characterized in that**
said light emitted from said light source (21) is modified when using said light of said light source (21) for said process step b) and said process step c), respectively.

**12.** The method according to any of the previous claims 9 to 12, **characterized in that**
said process step b) includes scribing an insulation line which electrically insulates at least a part of an active area (18) of said solar cell module (10) from an edge portion (17) of said solar cell module (10).

**13.** The method according to any of the previous claims 9 to 13, **characterized in that**
said process step b) includes scribing cell lines (14a, 14b,...) for electrically insulating a first area of said layer (14) from adjacent areas of said layer (14).

**14.** The method according to any of the previous claims 9 to 14, **characterized in that**
said process step c) includes scanning said surface of said solar cell module (10).

**15.** The method according to any of the previous claims 9 to 14, **characterized in that**
said method includes further process steps
d) Evaluating the measured signal; and
e) Changing an input parameter of said scribing tool when repeating said process step b) to generate another scribe line and/or repeating said process step b) to improve a generated scribe line.
